# EUROPÄISCHE PATENTSCHRIFT

(11) **EP 1 721 498 B1**
(45) Veröffentlichungstag und Bekanntmachung des Hinweises auf die Patenterteilung: **13.02.2008**
(21) Anmeldenummer: 05716697.7
(22) Anmeldetag: 15.02.2005
(51) Int. Cl.: H05K 1/18

(54) **ELEKTRONISCHE BAUGRUPPE UND VERFAHREN ZU DEREN HERSTELLUNG**
ELECTRONIC MODULE AND METHOD FOR THE PRODUCTION THEREOF
MODULE ELECTRONIQUE ET PROCEDE DE REALISATION

(30) Priorität: 23.02.2004 DE 102004008738
(43) Veröffentlichungstag der Anmeldung: 15.11.2006
(73) Patentinhaber: BSH Bosch und Siemens Hausgeräte GmbH, 81739 München (DE)
(72) Erfinder: GRADL, Markus, 93059 Regensburg (DE); KNOPP, Lothar, 12209 Berlin (DE); STEINEGGER, Rolf, 93049 Regensburg (DE)
(86) Internationale Anmeldenummer: PCT/EP2005/050649
(87) Internationale Veröffentlichungsnummer: WO 2005/081594

(56) Entgegenhaltungen:
- DE-A1- 19 816 445
- FR-A- 2 311 480
- US-A- 4 118 858
- US-A- 4 399 486
- US-A- 5 565 704
- US-B1- 6 333 471

## Beschreibung

Die vorliegende Erfindung betrifft eine elektronische Baugruppe, die zumindest einen zweiseitig mit einem elektrisch leitfähigem Material beschichteten Schaltungsträger aufweist, wobei der Schaltungsträger mit einer ersten Gruppe elektronischer Bauteile zur Gestaltung einer Benutzerschnittstelle und mit einer zweiten Gruppe elektronischer Bauteile zur Gestaltung eines Rechner- und Steuermoduls bestückt ist; die Erfindung betrifft ferner ein Verfahren zur Herstellung einer solchen Baugruppe.

Elektronische Baugruppen der eingangsgenannten Art sowie entsprechende Verfahren zum Herstellen einer solchen Baugruppe sind aus der Leiterplattenbestückungstechnik bekannt. Hierbei ist die Auswahl des Leiterplattenbasismaterials zur Fertigung der entsprechenden elektronischen Baugruppe von hoher Wichtigkeit, da das verwendete Basismaterial in erheblichem Maße mit über die elektrischen, mechanischen und hochfrequenztechnischen Eigenschaften sowie über die einsetzbaren Fertigungsverfahren und die zu erwarteten Kosten der zu fertigenden Platine bzw. Baugruppe entscheiden. Der Auswahl des richtigen Basismaterials kommt demzufolge eine wesentliche Bedeutung zu.

Bei mit Leiterplatten bestückten Haushaltgeräten, wie zum Beispiel Waschmaschinen, Geschirrspülern, Kühl-/Gefriergeräten und Herden, wird aus Kostengründen auf eine beidseitige Bestückung einer zweiseitig beschichteten Leiterplatte verzichtet, da dieses relativ teure Leiterplatten mit vorbereiteten Durchkontaktierungen notwendig machen würde. Aus diesem Grund werden zur Zeit in der Regel die relativ preisgünstigen, einseitig beschichteten Leiterplatten vom Typ CEM1 bzw. CEM3 eingesetzt. Jene Leiterplatten haben ihr Einsatzgebiet bei Massenanwendungen mit Forderungen nach verbesserten mechanischen und elektrischen Eigenschaften, wie es beispielsweise bei Haushaltgeräten der Fall ist. Jene Leiterplatten sind stanzbar, jedoch nur bedingt durchkontaktierbar. Der Nachteil von elektronischen Baugruppen, die auf einer einseitig beschichteten Leiterplatte angeordnet sind, liegt jedoch insbesondere in der begrenzten Platzierungsmöglichkeit von den Bauteilen, die die Baugruppe begründen, sowie in der eingeschränkten Möglichkeit der Entflechtung der Verbindungsmöglichkeiten.

Unter dem Begriff "Entflechtung einer Verbindungsmöglichkeit" ist in diesem Zusammenhang jene Eigenschaft gemeint, dass eine elektronische Baugruppe zur Ansteuerung eines Gerätes derart konzipiert ist, dass bestimmte Funktionsbereiche der Baugruppe räumlich getrennt voneinander als Module angeordnet sind, um möglichst flexibel das jeweilige Gerät an Änderungen hinsichtlich Designverbesserungen oder Funktionalitäten des Geräts anzupassen. Insbesondere bei modernen Haushaltgeräten werden designbeeinflusste Produktkriterien neu bewertet und zunehmend in der Gestaltung berücksichtigt. Die Weiterentwicklung eines derartigen Gerätes betrifft dabei tatsächlich im wesentlichen nur die Bedienfläche, also die Schnittstelle zwischen dem Gerät und dem Benutzter, wobei die eigentliche Elektronik des Gerätes in der Regel im Prinzip unverändert bleiben kann. Dies liegt daran, dass beim Entwurf von Haushaltgeräten das Design der Bedienfläche eine zunehmend wichtige Rolle spielt, da dieses beim Endkunden bei der Kaufentscheidung im wachsenden Maße beachtet wird. Es hat sich gezeigt, dass bei Geräten, die mit Leiterplatten bestückt sind, auf welchen die zugehörigen elektronische Baugruppe in einem sogenannten verflochtenen Zustand vorliegt, d.h. wobei die Elektronik in direktem Funktionszusammenhang mit beispielsweise der Benutzerschnittstelle steht, es bei einer Abänderung der Bedienfläche des Gerätes oftmals erforderlich ist, auch die Elektronik entsprechend zu modifizieren. Dies hat natürlich unerwünschte Zusatzkosten zur Folge.

Aus der DE 198 164 445 A1 ist eine Lösung bekannt, bei der elektronische Baugruppen eines elektrischen Gerätes auf jeweils einem einseitig beschichteten Schaltungsträger aufgebracht und kontaktiert sind, wobei nach der Bestückung der jeweiligen Schaltungsträger die jeweils unbestückten Flächen der Einzelleitungsträger aufeinander gelegt und entsprechend mechanisch fixiert werden. Der Nachteil bei diesem aus dem Stand der Technik bekannten Verfahren zur Herstellung einer derartigen Baugruppe liegt darin, dass die mechanisch verbundenen und übereinandergelegten Einzelplatten letztendlich zu dick sind, und ferner das Verfahren relativ kostenintensiv ist.

Der vorliegenden Erfindung liegt das technische Problem zugrunde, eine elektronische Baugruppe der eingangsgenannten Art sowie ein entsprechendes Verfahren zum Herstellen einer derartigen Baugruppe anzugeben, wobei eine Entflechtung von Verbindungsmöglichkeiten der entsprechenden Module möglich ist.

Diese Aufgabe wird bei einer elektronischen Baugruppe der eingangsgenannten Art dadurch gelöst, dass die erste Gruppe der elektronischen Bauteile zur Gestaltung der Benutzerschnittstelle bzw. des Benutzerschnittstellenmoduls auf einer ersten Seite des Schaltungsträgers und die zweite Gruppe der elektronischen Bauteile zur Gestaltung des Rechner- und Steuermoduls auf einer der ersten Seite gegenüberliegenden, zweiten Seite des Schaltungsträgers aufgebracht und kontaktiert sind.

Das der vorliegenden Erfindung zugrunde liegende technische Problem wird ferner durch ein Verfahren zum Herstellen der erfindungsgemäßen Baugruppe durch folgende Verfahrensschritte erfindungsgemäß gelöst: Bestücken der erste Seite des Schaltungsträgers mit einer ersten Gruppe der elektronischen Bauteile zur Gestaltung der Benutzerschnittstelle der Baugruppe; Bestücken der zweiten Seite des Schaltungsträgers mit einer zweiten Gruppe der elektronischen Bauteile zur Gestaltung eines Rechner- und Steuermoduls der Baugruppe; und Einrichten von Signalübertragungs- und/oder Leistungsversorgungsverbindungen zwischen der ersten Seite und der zweiten Seite.

Die Vorteile der Erfindung liegen insbesondere darin, dass durch die Entflechtung der elektronischen Bauteile zur Gestaltung der Benutzerschnittstelle von den elektronischen Bauteilen zur Gestaltung des Rechner- und Steuermoduls die jeweiligen Bauteilgruppen bzw. Module vollkommen gesondert voneinander entwickelt und angepasst werden können. Insbesondere ist es beispielsweise bei Haushaltgeräten möglich, die Realisierung eines neuen Designvorschlags für die Benutzerschnittstelle bzw. Bedienfläche des Gerätes vollkommen gesondert von der zu schaltenden Elektronik besonders kostengünstig und einfach umzusetzen. Von daher kann bei einer Weiterentwicklung des Gerätes auch auf bereits existierende Elektronik zurückgegriffen werden.

Die Vorteile der Verwendung eines zweiseitig beschichteten Schaltungsträgers bzw. die Vorteile einer zweiseitigen Bestückung des Schaltungsträgers sind ferner beachtlich, da dies die Möglichkeit bietet, die gleiche elektronische Schaltung auf einer wesentlich kleineren Baugruppe unterzubringen, als es der Fall bei einem einseitig beschichteten Schaltungsträger ist. Als mögliche Schaltungsträger- Basismaterialien kommt in bevorzugter Weise das CEM-1-, CEM-3- oder FR-4-Material zum Einsatz. Jene Materialien zeichnen sich - wie bereits angedeutet - durch verbesserte mechanische und elektrische Eigenschaften aus. Das FR-4-Basismaterial ist ferner für höhere Temperaturen ausgelegt und weist darüber hinaus eine erhöhte Kriechstromfestigkeit auf. Die genannten Materialien sind Standardmaterialien und aus der Leiterplattentechnik bekannt. Selbstverständlich können hierbei aber auch andere Basismaterialien für die Leiterplatten bzw. Schaltungsträger eingesetzt werden.

Mit dem erfindungsgemäßen Verfahren wird eine Möglichkeit für ein einfach zu realisierendes und dabei sehr effektives Herstellungsverfahren der erfindungsgemäßen elektronischen Baugruppe zur Optimierung der Entflechtung der einzelnen Bauteilegruppen angegeben. Dabei ist insbesondere vorgesehen, die mit der ersten Gruppe der elektronischen Bauteile zur Gestaltung der Benutzerschnittstelle bestückte erste Seite des Schaltungsträgers mittels Signalübertragungs- und/oder Leistungsversorgungsverbindungen mit der auf der zweiten Seite des Schaltungsträger bestückten zweiten Gruppe der elektronischen Bauteile zur Gestaltung des Rechner- und Steuermoduls zu verbinden. Erst dadurch wird es möglich, dass die erste Gruppe der elektronischen Bauteile vollkommen gesondert von der zweiten Gruppe der elektronischen Bauteile entwickelt bzw. angepasst werden kann. So ist es ferner denkbar, etwa zum Zwecke einer Realisierung eines neuen Designvorschlages für die Bedienfläche eines Haushaltgerätes, auf bereits existierende Elektronik zurückzugreifen, wobei es lediglich notwendig ist, die erste Gruppe der elektronischen Bauteile entsprechend den Änderungswünschen des neuen Designvorschlages anzupassen, während die zweite Gruppe der elektronischen Bauteile vollkommen unverändert bleibt. Durch das entsprechend angepasste Einrichten der Signalübertragungs- und/oder Leistungsversorgungsverbindungen zwischen der ersten Seite und der zweiten Seite des Schaltungsträgers ist es somit möglich, die Realisierung des neuen Designvorschlagen für die Bedienfläche besonders kostengünstig und einfach umzusetzen.

Bevorzugte Weiterbildungen der Erfindung sind bezüglich der elektronischen Baugruppe in den Unteransprüchen 2 bis 9 und bezüglich des Herstellungsverfahrens in den Unteransprüchen 11 bis 13 angegeben.

So ist für die elektronische Baugruppe bevorzugt vorgesehen, dass der Schaltungsträger frei von Durchkontaktierungsstellen, insbesondere von STH- Durchkontaktierungsstellen (STH= Silver Through Hole) ist, wobei zumindest eine Signalübertragungseinrichtung zum wechselseitigen Übertragen von Steuersignalen zwischen der ersten Gruppe der elektronischen Bauteile auf der ersten Seite des Schaltungsträgers und der zweiten Gruppe der elektronischen Bauteile auf der zweiten Seite des Schaltungsträgers und/oder zur Versorgung der ersten Seite mit elektrischer Leistung über die zweite Seite oder umgekehrt vorgesehen ist. Durch diese vorteilhafte Weiterentwicklung der elektronischen Baugruppe ist es insbesondere möglich, auf einfache Weise eine Trennung zwischen Blendendesign und Funktion auf einer Leiterplatte durchzuführen. Unter dem Begriff "Blendendesign" fallen sämtlich variantenbildenden Bedien- und Anzeigeelemente auf der Vorderseite des Schaltungsträgers, während unter dem Begriff "Funktion" die Varianten-unabhängige Funktion auf der Rückseite des Schaltungsträgers zu verstehen ist.

In einer besonders bevorzugten Weiterentwicklung der letztgenannten Ausführungsform der erfindungsgemäßen elektronischen Baugruppe ist vorgesehen, dass die Signalübertragungseinrichtung zumindest ein Steckelement aufweist, welches an einem Bereich des Schaltungsträger über gegenüberliegende, auf der ersten und der zweiten Seite des Schaltungsträgers ausgebildete und miteinander konjugierende Steckbereich gesteckt wird. Um in dieser Ausführungsform Signale von der ersten Gruppe der elektronischen Bauteile von der ersten Schaltungsträgerseite, die auch "Blendenseite" genannt wird, da sie zur Bedienblende des Geräts zeigt, der zweiten Gruppe der elektronischen Bauteile auf der zweiten, auch "Geräteseite" genannten Schaltungsträgeseite zuzuführen, werden die Signale auf der Blendenseite zu einem Randbereich geführt und mittels des Steckelementes, wie etwa mittels eines Randkartensteckers, auf die Blendenseite gebracht. Dabei ist vorgesehen, dass sich der Master-Mikrokontroller des Geräts auf der Geräteseite, d.h. auf der Schaltungsträgerseite, die zum Geräteinneren zeigt, befindet. Bei der Anordnung bzw. Auslegung der jeweiligen Steckbereiche auf der ersten und der zweiten Seite des Schaltungsträgers ist es ferner denkbar, an den jeweiligen Randbereichen des Schaltungsträgers eine stufenförmig abgesetzte Ausnehmung vorzusehen. Dabei können die Steckelemente der jeweiligen Breite der Ausnehmung angepasst werden, so dass eine Sicherung der Steckelemente gegen seitliches Verschieben erreicht wird. Denkbar ist ferner, den Steckbereich an dem Randbereich des Schaltungsträgers so auszuführen, dass dieser auch parallel zum Anschluss weiterer Elektronikmodule per Steckelement bzw. Randkartenstecker mit angeschlossenen Leitungen genutzt werden kann. Somit ist es möglich, die Steckbereiche nicht nur als Schnittstellen zwischen der ersten und der zweiten Seite des Schaltungsträgers sondern auch als Schnittstellen des gesamten Schaltungsträgers zu anderen Schaltungsträgern zu verwenden. Selbstverständlich sind hier aber auch andere Ausführungsformen denkbar.

In einer besonders bevorzugten Realisierung der elektronischen Baugruppe ist vorgesehen, dass die Signalübertragungseinrichtung zumindest ein Leiterelement, insbesondere einen Kabel-Jumper, aufweist, wobei jenes Leiterelement einen ersten Kontaktbereich auf der ersten Seite des Schaltungsträgers mit einem zweiten Kontaktbereich auf der zweiten Seite des Schaltungsträgers elektrisch verbindet. Eine derartige Signalübertragungseinrichtung in der Gestalt eines Leiterelementes ist beispielsweise zur Leistungsversorgung der jeweiligen Bauteilgruppen auf der ersten bzw. zweiten Seite nutzbar, da das Leiterelement auf einer besonders leicht zu realisierenden Weise an die entsprechenden Bedingungen, wie Spannungsfestigkeit etc., angepasst ausgelegt werden kann. Hier ist Beispielsweise denkbar, dass die zweite Seite des Schaltungsträgers über ein Steckelement mit einem Netzteil und wiederum über ein Leiterelement mit der ersten Seite des Schaltungsträgers verbunden ist, um derart die Spannungsversorgung der beidseitig bestückten Bauteilegruppen bzw. Module zu gewährleisten.

Besonders vorteilhaft ist es, dass die Signalübertragungseinrichtung zumindest ein Durchkontaktierungselement aufweist, dass durch ein Durchgangsloch in dem Schaltungsträger hindurchläuft und einen ersten Kontaktbereich auf der ersten Seite des Schaltungsträgers mit einem zweiten Kontaktbereich auf der zweiten Seite des Schaltungsträgers elektrisch verbindet. Dabei ist denkbar, dass jenes Durchgangsloch in den Schaltungsträger durch Stanzen, Bohren, Laserbohren oder aber auch durch Fräsen eingebracht wird. Mit dieser besonders bevorzugten Realisierung der erfindungsgemäßen elektronischen Baugruppe ist es möglich, obwohl das Leiterplatten-Basismaterial aus Kostengründen bewusst von vornherein frei von Durchkontaktierungen ist, dennoch auf die aus der Leiterplattentechnik bekannten Vorteile hinsichtlich Durchkontaktierungsstellen, wie etwa STH- Durchkontaktierungen, zurückzugreifen, indem die fehlenden Durchkontaktierungsstellen individuell durch Durchkontaktierungselemente ersetzt werden. Dieses ist eine besonders preisgünstige Möglichkeit zu Realisierung der vorteilhaften Durchkontaktierungen.

Dabei ist in besonders vorteilhafter Weise vorgesehen, dass das Durchkontaktierungselement ein insbesondere aus Blech ausgebildetes Steckelement ist, welches eine ebene Kontaktfläche und einen Stiftbereich aufweist, welcher über einen Federabschnitt federnd mit der Kontaktfläche verbunden ist, wobei die Kontaktfläche bündig auf dem Kontaktbereich des Schaltungsträgers anliegt und wobei der Stiftbereich durch das Durchgangsloch hindurchläuft, wenn das Steckelement als Durchkontaktierungselement in dem Durchgangsloch eingesetzt ist. Besonders bevorzugt ist die ebene Kontaktfläche des Steckelementes dabei derart ausgelegt, dass diese in einer besonders leicht zu realisierenden Weise mit dem entsprechenden Kontaktbereich des Schaltungsträgers kontaktiert werden kann. Der Federabschnitt, der die Kontaktfläche mit dem Stiftbereich verbindet, dient unter anderem dazu, das Steckelement sicher in dem Durchgangsloch zu fixieren, bevor das Element durch beispielsweise Löten mit den entsprechenden Kontaktbereichen des Schaltungsträgers fest verbunden und kontaktiert wird. Selbstverständlich sind hier aber auch andere Ausführungsformen und Ausgestaltungsformen des Steckelementes denkbar. So ist es möglich, das Steckelement aus einem Material auszubilden, das an die entsprechenden Anforderungen individuell angepasst ist. Denkbar wäre beispielsweise als Basismaterial für das Steckelement ein elektrisch leitfähiges Polymer zu verwenden.

Um zu erreichen, dass auf dem Schaltungsträger beidseitig SMD- Bauteile (SMD= Surface Monted Device) und einseitig bedrahtete, bzw. THD- Bauteile (THD= Through Hole Device) verwendbar sind, sind die ersten Gruppe der elektronischen Bauteile derartige Bauteile, die mittels einer SMD- Technologie auf einem SMD-Bereich auf der ersten Seite des Schaltungsträgers bestückt werden, wohingegen die zweite Gruppe der elektronischen Bauteile derartige Bauteile sind, die sowohl mittels einer SMD- Technologie auf einem SMD- Bereich der zweiten Seite des Schaltungsträgers als auch mittels einer THD- Technologie auf einem THD- Bereich der zweiten Seite des Schaltungsträgers bestückt werden. Dabei ist vorgesehen, dass der THD- Bereich der zweiten Seite verschieden vom SMD- Bereich der zweiten Seite ist, und dass der SMD- Bereich der zweiten Seite ein dem SMD- Bereich der ersten Seite entsprechender und gegenüberliegender Bereich ist.

Denkbar hierbei wäre jedoch auch, dass die erste Gruppe der elektronischen Bauteile derartige Bauteile sind, die sowohl mittels einer SMD- Technologie auf einem SMD- Bereich der ersten Seite des Schaltungsträgers als auch mittels einer THD-Technologie auf einem THD- Bereich der ersten Seite des Schaltungsträgers bestückt werden, wohingegen die zweite Gruppe der elektronischen Bauteile derartige Bauteile sind, die mittels einer SMD- Technologie auf einem SMD- Bereich der zweiten Seite des Schaltungsträgers bestückt werden. Dabei ist vorgesehen, dass der THD- Bereich der ersten Seite verschieden vom SMD- Bereich der ersten Seite und der SMD-Bereich der zweiten Seite ein dem SMD- Bereich der ersten Seite entsprechender und gegenüberliegender Bereich ist.

Die entsprechenden Löttechniken in der Elektronikfertigung, insbesondere die THD- Technologie für durchsteckmontierte Bauelemente und die SMD-Technologie für oberflächenmontierte Bauelemente sind aus dem Stand der Technik bekannt und werden hier nicht näher erläutert.

Als vorteilhafte Weiterbildung des erfindungsgemäßen Herstellungsverfahrens ist vorgesehen, dass bei dem Verfahrensschritt des Einrichtens von Signalübertragungs- und/oder Leistungsversorgungsverbindungen zwischen der ersten Seite und der zweiten Seite des Schaltungsträgers Steckbereiche ausgebildet werden, die sich an einem Randbereich gegenüberliegend und miteinander konjugierend auf der ersten Seite und der zweiten Seite des Schaltungsträgers erstrecken, wobei anschließend Steckelemente auf die gegenüberliegend ausgebildeten und miteinander konjugierenden Steckbereiche aufgesteckt werden.

Besonders bevorzugt werden zur Einrichtung von Signalübertragungsverbindungen zumindest ein Kontaktbereiche auf der ersten Seite des Schaltungsträgers und zumindest ein Kontaktbereich auf der zweiten Seite des Schaltungsträgers ausgebildet, die anschließend mit einem Leiterelement, wie etwa einem Kabel-Jumper, verbunden werden.

Hinsichtlich einer weiteren, besonders bevorzugten Ausführungsform des erfindungsgemäßen Verfahrens ist ferner vorgesehen, dass zumindest ein Durchgangsloch in dem Schaltungsträger, zumindest ein erster Kontaktbereich auf der ersten Seite des Schaltungsträgers und zumindest ein zweiter Kontaktbereich auf der zweiten Seite des Schaltungsträgers ausgebildet werden und anschließend ein Durchkontaktierungselement in das zumindest eine Durchgangsloch eingesetzt wird, um den zumindest einen ersten Kontaktbereich mit dem zumindest einem zweiten Kontaktbereich elektrisch zu verbinden.

Weitere Vorteile und Zweckmäßigkeiten der Erfindung werden im Übrigen aus der nachfolgenden Beschreibung der bevorzugten Ausführungsformen anhand der Figuren deutlich.

Es ist zeigen:

Fig. 1 die Blendenseite einer ersten bevorzugten Ausführungsform der erfindungsgemäßen elektronischen Baugruppe;

Fig. 2 die zu der in Fig. 1 dargestellten Blendenseite zugehörige Geräteseite der erfindungsgemäßen elektronischen Baugruppe gemäß der ersten Ausführungsform;

Fig. 3 die Blendenseite einer weiteren bevorzugten Ausführungsform der erfindungsgemäßen elektronischen Baugruppe;

Fig. 4 die zur Blendenseite der in Fig. 3 dargestellten Ausführungsform der erfindungsgemäßen elektronischen Baugruppe zugehörige Geräteseite;

Fig. 5 eine schematische Darstellung einer weiteren Ausführungsform der erfindungsgemäßen elektronischen Baugruppe im eingebauten Zustand;

Fig. 6 eine dreidimensionale Darstellung einer Ausführungsform des erfindungsgemäßen Durchkontaktierungselements.

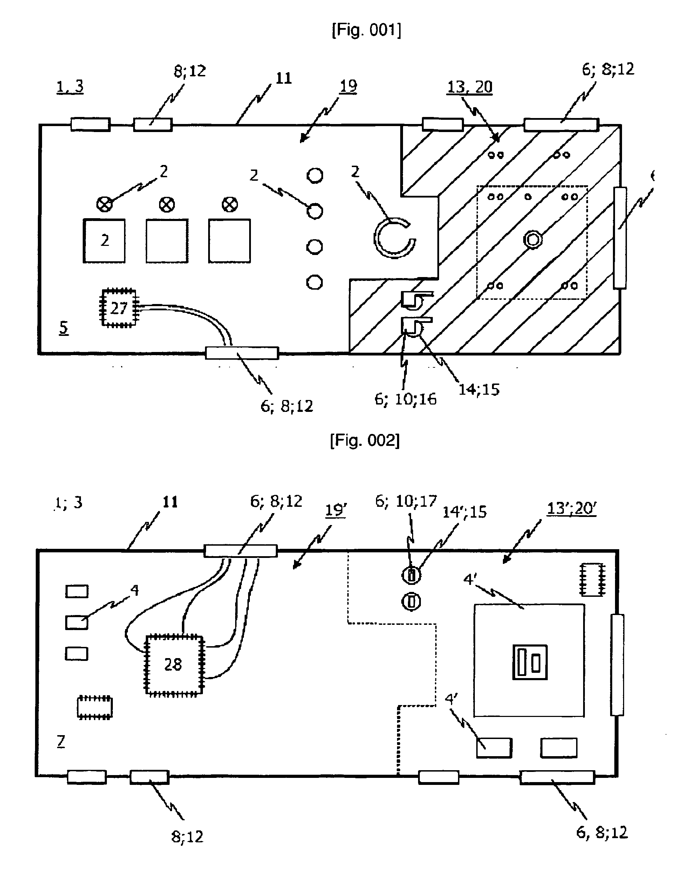

Fig. 1 zeigt die Blendenseite 5 einer bevorzugten Ausführungsform der elektronischen Baugruppe 1. Bei der hier dargestellten Ausführungsform handelt es sich um eine erste Variante der Baugruppe 1, bei der sich auf der Blendenseite 5 auf einem SMD-Bereich 19 SMD-Bauteile 2 und der Schwall-Lötbereich 20 der auf der Geräteseite 7 eingesetzten THD-Bauteile 4' befinden.

Fig. 2 zeigt die zu der in Fig. 1 dargestellten Blendenseite 5 zugehörige Geräteseite 7 der ersten bevorzugten Ausführungsform der elektronischen Baugruppe 1. Auf der Geräteseite 7 befinden sich sowohl SMD-Bauteile 4 als auch die THD-Bauteile 4', wobei die THD-Bauteile 4' auf einem THD-Bereich 20' der Geräteseite 7 angeordnet sind, welcher dem Schwall-Lötbereich 20 der Blendenseite 5 genau gegenüberliegt. Die SMD-Bauteile 4 können auf der Geräteseite 7 sowohl auf dem THD-Bereich 20' als auch auf dem SMD-Bereich 19' angeordnet sein. Der SMD-Bereich 19' der Geräteseite 7 liegt dem SMD-Bereich 19 der Blendenseite 5 genau gegenüber.

Bezug nehmend auf Fig. 1 sind auf der Blendenseite 5 der elektronischen Baugruppe 1 in dem SMD-Bereich 19 eine erste Gruppe elektronischer Bauteile 2 zur Gestaltung einer Benutzerschnittstelle bestückt. Diese erste Gruppe der elektronischen Bauteile 2 setzt sich beispielsweise aus Schaltern, Tastern, Potentiometern, Anzeigeelementen, Siebensegementanzeigen, Leuchtdioden und ähnlichen elektronischen Komponenten zusammen. Diese elektronischen Komponenten sind jeweils SMD-Bauteile, d.h. Bauteile, die mittels einer aus dem Stand der Technik bekannten SMD-Technologie auf der Oberfläche 5 der Platine bestückt wurden. Die SMD-Technologie weist dabei üblicherweise die Verfahrensschritte des Dispensens, des Bestückens und des anschließenden Kontaktierens der Bauteile 2 auf. Jene Schritte sind aus dem Stand der Technik bekannt und werden hier nicht näher erläutert.

Wie in der Fig. 1 gezeigt, kann auf der Blendenseite 5 in dem SMD-Bereich 19 der Baugruppe 1 ferner optional ein Mikrocontroller 27 angeordnet sein, der zur Steuerung bzw. Ansteuerung der ebenfalls auf der Blendenseite 5 angeordnete, elektronischen Bauteile 2 der ersten Gruppe zur Gestaltung der Benutzerschnittstelle vorhanden ist. In diesem Zusammenhang ist jener Mikrocontroller 27 ebenfalls als ein Bauteil 2 der ersten Gruppe anzusehen, da er in erster Linie zur Gestaltung der Benutzerschnittstelle der elektronischen Baugruppe 1 dient.

Gemäß der Fig. 2 sind auf der Geräteseite 7 sowohl SMD-Bauteile 4 als auch THD-Bauteile 4' vorgesehen. Die SMD-Bauteile 4 liegen auf dem SMD-Bereich 19', der genau gegenüber dem SMD-Bereich 19 der Blendenseite 5 positioniert ist. Auf ähnliche Weise sind die THD-Bauteile 4' bzw. die bedrahteten Bauteile 4' auf der Geräteseite 7 in dem Bereich 20' angeordnet, der dem SMD-Bereich 20 der Blendenseite 5 entspricht und gegenüberliegt. Die auf der Geräteseite 7 angeordneten Bauteile 4, 4' gehören zu einer zweiten Gruppe elektronischer Bauteile, die zur Gestaltung eines Rechner- und Steuermoduls der elektronischen Baugruppe 1 dienen. Jene elektronischen Bauteile 4, 4' der zweiten Gruppe setzen sich aus dem Master-Mikrocontroller 28 und den zugehörigen Schaltungen bzw. Chips zusammen.

Bei der elektronischen Baugruppe 1 gemäß der ersten Ausführungsform wird als Schaltungsträger-Basismaterial das CEM-1-, CEM-3- oder SR-4-Material verwendet. Jene Materialen zeichnen sich durch verbesserte mechanische und elektrische Eigenschaften aus. Dabei ist vorgesehen, dass die Basismaterialien zweiseitig beschichtet sind. Um die Herstellungskosten der elektronischen Baugruppe 1 zu reduzieren, wird bewusst bei den Leiterplatten-Basismaterialien auf bereits vorab eingebrachte Durchkontaktierungsstellen, insbesondere STH-Durchkontaktierungen, verzichtet. Zum wechselseitigen Übertragen von Steuersignalen zwischen den Bauteilen 2 der Blendenseite 5 und den Bauteilen 4, 4' der Geräteseite 7 sind stattdessen Signalübertragungseinrichtungen 6 vorgesehen. Diese Signalübertragungseinrichtungen 6 dienen des weiteren zur Versorgung der elektronischen Bauteile 2 der Blendenseite 5 mit elektrischer Leistung über die Geräteseite 7 oder umgekehrt.

Gemäß der in den Figuren 1 und 2 dargestellten ersten bevorzugten Ausführungsform der erfindungsgemäßen elektronischen Baugruppe 1 sind als Signalübertragungseinrichtungen 6 Steckelemente 8 sowie Durchkontaktierungselemente 10 vorgesehen. Die Steckelemente 8 werden an jeweiligen Randbereichen 11 des Schaltungsträgers 3 aufgebracht. Hierzu wurden an den jeweiligen Positionen des Randbereichs 11 des Schaltungsträgers 3 sogenannte Steckbereiche 12 ausgebildet. Damit verbinden diese Steckelemente 8 die gegenüberliegenden, auf der Blenden- und der Geräteseite 5, 7 des Schaltungsträgers ausgebildete und miteinander konjugierende Steckbereiche 12 elektrisch. Die Steckbereiche 12 selber sind über Leiterbahnen (nicht explizit dargestellt) mit den jeweiligen Bauteilen 2, 4, 4' elektrisch verbunden; denkbar ist jedoch auch, dass die Steckbereiche 12 zumindest teilweise über Bondingdrähte oder anderen Drähten mit den jeweiligen Anschlüssen der Bauteile 2, 4, 4' verbunden sind.

Als weitere Signalübertragungseinrichtungen 6 sind in der ersten bevorzugten Ausführungsform der erfindungsgemäßen elektronischen Baugruppe 1 ferner Durchkontaktierungselemente 10 vorgesehen, die jeweils durch ein Durchgangsloch 15 in dem Schaltungsträger 3 hindurchlaufen und einen ersten Kontaktbereich 14 der Blendenseite 5 des Schaltungsträgers 3 mit einem zweiten Kontaktbereich 14' auf der Geräteseite 7 des Schaltungsträgers 3 elektrisch verbinden. Dabei ist vorgesehen, dass die jeweiligen Durchgangslöcher 15 in dem Schaltungsträger 3 durch Stanzen, Bohren, Laserbohren oder aber auch durch Fräsen eingebracht werden. In der Fig. 1 ist ferner zu erkennen, dass der erste Kontaktbereich 14 der Durchkontaktierungselemente 10 in den Schwallbereich 20 der Blendenseite 5 fällt. Das Durchkontaktierungselement 10 kann demgemäß als ein THD-Bauteil 4' betrachtet werden, dass beispielsweise mittels Schwalllöten fixiert und entsprechend kontaktiert wird.

Die erste Ausführungsform der erfindungsgemäßen elektronischen Baugruppe 1 zeichnet sich dadurch aus, dass auf der Blendenseite 5 nur jene elektronischen Bauteile 2 angeordnet sind, die zur Gestaltung der Benutzerschnittstelle der Baugruppe 1 dienen, während auf der Geräteseite 7 die Bauteile 4, 4' zur Gestaltung des Rechner- und Steuermoduls der Baugruppe 1 vorliegen. Dadurch liegt eine vollständige Entflechtung der elektronischen Bauteile 2, 4, 4' vor. Durch die Anordnung der Bauteile 2, 4, 4' gemäß der ersten Ausführungsform der vorliegenden Erfindung wird erreicht, dass bei Designänderungen bzw. Änderungen der Benutzerschnittstelle nur das Layout der Blendenseite 5 geändert werden muss. Hingegen kann das Layout der Geräteseite 7 unverändert bleiben, was die im Zusammenhang mit der Designveränderung anfallenden Kosten und den Zeitaufwand reduziert.

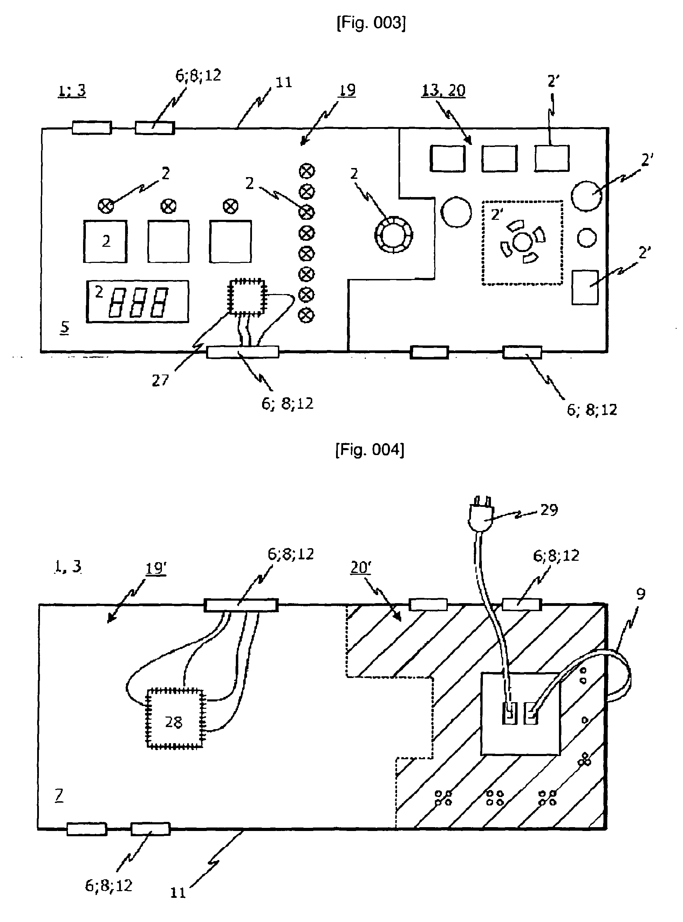

Fig. 3 zeigt die Blendenseite 5 einer zweiten bevorzugten Ausführungsform der erfindungsgemäßen elektronischen Baugruppe 1.

Fig. 4 zeigt die zu der in Fig. 3 dargestellten Blendenseite 5 zugehörige Geräteseite 7 jener elektronischen Baugruppe 1 der zweiten bevorzugten Ausführungsform.

Die zweite bevorzugte Ausführungsform unterscheidet sich von der ersten bevorzugten Ausführungsform gemäß den Figuren 1 und 2 dadurch, dass sich nun auf der Blendenseite 5 sowohl SMD-Bauteile 2 als auch bedrahtete bzw. THD-Bauteile 2' befinden. Auf der entsprechenden Geräteseite 7 können sich somit (nicht dargestellte) SMD-Bauteile und der Schwalllötbereich 20' der bedrahteten Bauteile 2' der Blendenseite 5 befinden.

In Analogie zu der ersten bevorzugten Ausführungsform der elektronischen Baugruppe 1 sind wiederum die zur Ausgestaltung des Blendendesigns verwendeten Bauteile 2, 2' ausschließlich auf der Blendenseite 5 angeordnet, während auf der Geräteseite 7 die Bauteile 4 vorliegen, die zur Gestaltung des Rechner- und Steuermoduls dienen. Aus Kostengründen ist die elektronische Baugruppe 1 gemäß der zweiten Ausführungsform ebenfalls aus einer zweiseitig mit einem elektrisch leitfähigen Material beschichteten Schaltungsträger 3 aufgebaut, wobei der Schaltungsträger 3 frei von Durchkontaktierungsstellen, insbesondere STH-Durchkontaktierungsstellen, ist. Die fehlenden Durchkontaktierungsstellen werden in Analogie zur ersten bevorzugten Ausführungsform mittels Signalübertragungseinrichtungen 6 in der Gestalt von Steckelementen 8 und miteinander konjugierenden Steckbereichen 12 ersetzt.

Einen Unterschied der zweiten bevorzugten Ausführungsform hinsichtlich der ersten bevorzugten Ausführungsform ist ferner darin zu sehen, dass hier bewusst nun auf Signalübertragungseinrichtungen 6 in der Gestalt von Durchkontaktierungselementen 10 verzichtet wird, stattdessen Leiterelemente 9, wie etwa Kabel-Jumper, vorgesehen sind, die einen ersten Kontaktbereich 13 auf der Blendenseite 5 des Schaltungsträgers 1 mit einem zweiten Kontaktbereich 13' auf der zweiten Seite 7 des Schaltungsträgers 1 elektrisch verbinden. Ferner ist auf der Geräteseite 7 ein Leiterelement 29 vorgesehen, dass zur Leistungsversorgung der elektronischen Baugruppe dient.

Ebenfalls ist auf der Blendenseite 5 der zweiten Ausführungsform optional ein Mikrocontroller 27 vorgesehen, der zur Ansteuerung bzw. zur Steuerung der auf der Blendenseite 5 vorliegenden Bauteile 2, 2' zur Gestaltung der Benutzerschnittstelle dient, und hierin ebenfalls als Bauteil 2, 2', das zur ersten Gruppe zugehört, angesehen wird.

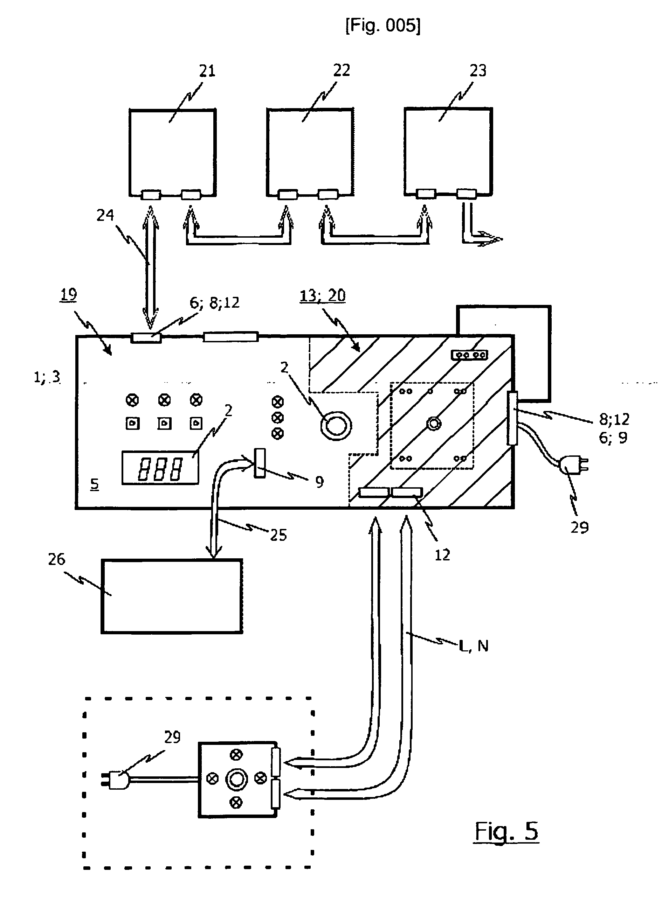

Fig. 5 zeigt eine schematische Darstellung einer weiteren Ausführungsform der erfindungsgemäßen elektronischen Baugruppe 1 im eingebauten Zustand. In der dargestellten Ausführungsform liegt eine Sichtweise auf die Blendenseite 5 der elektronischen Baugruppe 1 vor. Die elektronische Baugruppe 1 ist in Analogie zur ersten bevorzugten Ausführungsform der Figuren 1 und 2 ausgebildet, d.h. auf der Blendenseite 5 befinden sich SMD-Bauteile 2 und der Schwall-Lötbereich 20 der auf der Geräteseite 7 angeordneten bedrahteten bzw. THG-Bauteile 4'. Wie dargestellt kommuniziert die elektronische Baugruppe 1 über ein als Randstecker ausgebildetes Steckelement 8 mit einem Antriebsmodul 21 das wiederum mit einem Sensormodul 22 und einem Aktormodul 23 in Verbindung steht. Die Kommunikation zwischen der Baugruppe 1 und dem Antriebsmodul 21 erfolgt über einen D-Bus 24, der an den Randstecker bzw. das Steckelement 8 an der elektronischen Baugruppe 1 angeordnet ist.

Über ein Leiterelement 9 auf der Blendenseite 5 der elektronischen Baugruppe 1 wird ein SPI-D-Bus 25 angeschlossen, der mit einem Display 26 verbunden ist. Ebenfalls über ein Leiterelement 9, das jedoch im Schwall-Lötbereich 20 der Blendenseite 5 angeordnet ist, erfolgt eine Leistungsversorgung der Baugruppe 1. Optional ist denkbar, beispielsweise ein externes Programmwählermodul mit Lichtdesign an die elektronische Baugruppe 1 über einen oder mehrere Busse 24, 25 anzuschließen, wobei die Kontaktierung auf dem Schwall-Lötbereich 20 der Blendenseite 5 über Leiterelemente 9 erfolgt. Ferner kann ein zusätzliches Netzteil zur Leisungsversorgung der elektronischen Baugruppe bei Bedarf vorgesehen sein.

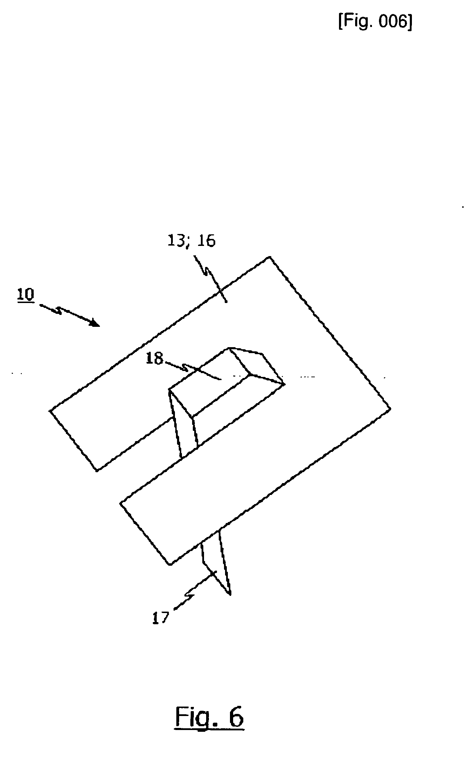

Fig. 6 zeigt eine dreidimensionale Ansicht einer möglichen Ausführungsform des erfindungsgemäßen Durchkontaktierungselements 10. Jenes Durchkontaktierungselement 10 läuft im eingesetzten Zustand durch ein Durchgangsloch 15 in dem Schaltungsträger 3 hindurch und verbindet einen ersten Kontaktbereich 14 auf der einen Seite 5, 7 des Schaltungsträgers 3 mit einem zweiten Kontaktbereich 14' auf der zweiten Seite des Schaltungsträgers 7, 5. Hierbei ist beispielsweise denkbar, dass auf der Oberseite des Durchkontaktierungselements 10, die der Kontaktfläche 16 entspricht, die Kontaktierung des Durchkontaktierungselements 10 durch Reflow-Löten erfolgt, während die Unterseite bzw. der Stiftbereich 17 des Durchkontaktierungselements 10 mittels Schwall-Löten fixiert bzw. mit den jeweiligen Kontaktbereichen 14, 14' elektrisch verbunden wird:

Das dargestellte Durchkontaktierungselement 10 ist ein, insbesondere aus Blech, ausgebildetes Steckelement, welches eine ebene Kontaktfläche 16 und einen Stiftbereich 17 aufweist, welcher über einen Federabschnitt 18 federnd mit der Kontaktfläche 16 verbunden ist, wobei die Kontaktfläche 16 bündig auf dem Kontaktbereich 14, 14' des Schalterträgers 3 anliegt und wobei der Stiftbereich 17 durch das Durchgangsloch 15 hindurch läuft, wenn das Durchkontaktierungselement 10 in dem Durchgangsloch 15 eingesetzt ist.

Die Vorteile der erfindungsgemäßen elektrischen Baugruppe 1 gemäß den obig beschriebenen bevorzugten Ausführungsformen gegenüber bekannten Lösungen sind insbesondere in der Entkopplung von Design und Funktion durch geschickte Anordnung der Bauteile 2, 2', 4, 4' auf je einer Leiterplattenseite 5,7, in den Kosteneinsparungen durch Wegfall eines separaten Bedienmoduls, das bei bisherigen Lösungen die designrelevanten Bauteile aufnimmt und durch Bauraumeinsparungen durch Wegfall des separaten Bedienmoduls zu sehen.

**Bezugszeichenliste**

1 Elektronische Baugruppe

2 Elektronische Bauteile der ersten Gruppe (SMD-Bauteile)

2' Elektronische Bauteile der ersten Gruppe (THD-Bauteile)

3 Schaltungsträger

4 Elektronische Bauteile der zweiten Gruppe (SMD-Bauteile)

4' Elektronische Bauteile der zweiten Gruppe (THD-Bauteile)

5 Erste Seite bzw. Blendenseite

6 Signalübertragungseinrichtung

7 Zweite Seite bzw. Geräteseite

8 Steckelement

9 Seitenelement, Leiterelement

10 Durchkontaktierungselement

11 Randbereich

12 Steckbereich

13, 13' Kontaktbereich

14, 14' Kontaktbereich

15 Durchgangsloch

16 Kontaktfläche

17 Stiftbereich

18 Federabschnitt

19, 19' SMD-Bereich der ersten / zweiten Seite

20, 20' THD-Bereich der ersten / zweiten Seite

21 Antriebsmodul

22 Sensormodul

23 Aktormodul

24 D-Bus

25 SPI-G-Bus

26 Display

27 Mikro-Controller

28 Master-Controller

29 Leiterelement zur Leistungsversorgung

## Patentansprüche

1. Elektronische Baugruppe, die zumindest einen zweiseitig mit einem elektrisch leitfähigem Material beschichteten Schaltungsträger (3) aufweist, wobei der Schaltungsträger (3) mit einer ersten Gruppe elektronischer Bauteile (2) zur Gestaltung einer Benutzerschnittstelle und mit einer zweiten Gruppe elektronischer Bauteile (4) zur Gestaltung eines Rechner- und Steuermoduls bestückt ist, **dadurch gekennzeichnet, dass** die erste Gruppe der elektronischen Bauteile (2) zur Gestaltung der Benutzerschnittstelle auf einer ersten Seite (5) des Schaltungsträgers (3) und die zweite Gruppe der elektronischen Bauteile (4) zur Gestaltung des Rechner- und Steuermoduls auf einer der ersten Seite (5) gegenüberliegenden, zweiten Seite (7) des Schaltungsträgers (3) aufgebracht und kontaktiert sind.

2. Elektronische Baugruppe gemäß Anspruch 1, **dadurch gekennzeichnet, dass** der Schaltungsträger (3) frei von Durchkontaktierungsstellen, insbesondere STH-Durchkontaktierungsstellen, ist.

3. Elektronische Baugruppe gemäß Anspruch 1 oder 2, **dadurch gekennzeichnet, dass** der Schaltungsträger (3) zumindest eine Signalübertragungseinrichtung (6) anweist zum wechselseitigen Übertragen von Steuersignalen zwischen der ersten Gruppe der elektronischen Bauteile (2) auf der ersten Seite (5) des Schaltungsträgers (3) und der zweiten Gruppe der elektronischen Bauteile (4) auf der zweiten Seite (7) des Schaltungsträgers (3) und/oder zur Versorgung der ersten Seite (5) mit elektrischer Leistung über die zweite Seite (7) oder umgekehrt.

4. Elektronische Baugruppe gemäß Anspruch 3, **dadurch gekennzeichnet, dass** die Signalübertragungseinrichtung (6) zumindest ein Steckelement (8) aufweist, das an einem Randbereich (11) des Schaltungsträgers (3) über gegen-überliegende, auf der ersten und der zweiten Seite (5;7) des Schaltungsträgers (3) ausgebildete und miteinander konjugierende Steckbereiche (12) gesteckt wird.

5. Elektronische Baugruppe gemäß Anspruch 3 oder 4, **dadurch gekennzeichnet, dass** die Signalübertragungseinrichtung (6) zumindest ein Leiterelement (9), insbesondere einen Kabel-Jumper, aufweist, das einen ersten Kontaktbereich (13) auf der ersten Seite (5) des Schaltungsträgers (3) mit einem zweiten Kontaktbereich (13') auf der zweiten Seite (7) des Schaltungsträgers (3) elektrisch verbindet.

6. Elektronische Baugruppe gemäß einem der Ansprüche 3 bis 5, **dadurch gekennzeichnet, dass** die Signalübertragungseinrichtung (6) zumindest ein Durchkontaktierungselement (10) aufweist, das durch ein Durchgangsloch (15) in dem Schaltungsträger (3) hindurchläuft und einen ersten Kontaktbereich (14) auf der ersten Seite (5) des Schaltungsträgers (3) mit einem zweiten Kontaktbereich (14') auf der zweiten Seite (7) des Schaltungsträgers (3) elektrisch verbindet.

7. Elektronische Baugruppe gemäß Anspruch 6, **dadurch gekennzeichnet, dass** das Durchkontaktierungselement (10) ein insbesondere aus Blech ausgebildetes Steckelement ist, welches eine ebene Kontaktfläche (16) und einen Stiftbereich (17) aufweist, welcher über einen Federabschnitt (18) federnd mit der Kontaktfläche (16) verbunden ist, wobei die Kontaktfläche (16) bündig auf dem Kontaktbereich (14,14') des Schaltungsträgers (3) anliegt und wobei der Stiftbereich (17) durch das Durchgangsloch (15) hindurchläuft, wenn das Steckelement (10) als Durchkontaktierungselement (10) in dem Durchgangsloch (15) eingesetzt ist.

8. Elektronische Baugruppe gemäß einem der vorhergehenden Ansprüche, **dadurch gekennzeichnet, dass** die erste Gruppe der elektronischen Bauteile (2) mittels einer SMD- Technologie auf einem SMD- Bereich (19) der ersten Seite (5) des Schaltungsträgers (3) bestückte Bauteile sind und die zweite Gruppe der elektronischen Bauteile (4) sowohl mittels einer SMD- Technologie auf einem SMD-Bereich (19') der zweiten Seite (7) des Schaltungsträgers (3) bestückte Bauteile als auch mittels einer THD- Technologie auf einem THD- Bereich (20') der zweiten Seite (7) des Schaltungsträgers (3) bestückte Bauteile sind, wobei der THD- Bereich (20') der zweiten Seite (7) verschieden vom SMD- Bereich (19') der zweiten Seite (7) ist und wobei der SMD- Bereich (19') der zweiten Seite (7) ein dem SMD- Bereich (19) der ersten Seite (3) entsprechender und gegenüberliegender Bereich ist.

9. Elektronische Baugruppe gemäß einem der Ansprüche 1 bis 7, **dadurch gekennzeichnet, dass** die erste Gruppe der elektronischen Bauteile (2) sowohl mittels einer SMD- Technologie auf einem SMD- Bereich (19) der ersten Seite (5) des Schaltungsträgers bestückte Bauteile als auch mittels einer THD-Technologie auf einem THD- Bereich (20) der ersten Seite (5) des Schaltungsträgers (3) bestückte Bauteile sind, und die zweite Gruppe der elektronischen Bauteile (4) mittels einer SMD- Technologie auf einem SMD-Bereich (19') der zweiten Seite (7) des Schaltungsträgers (3) bestückte Bauteile sind, wobei der THD- Bereich (20) der ersten Seite (5) verschieden vom SMD-Bereich (19) der ersten Seite (5) ist und wobei der SMD- Bereich (19') der zweiten Seite (7) ein dem SMD- Bereich (19) der ersten Seite (3) entsprechender und gegenüberliegender Bereich ist.

10. Verfahren zum Herstellen einer elektronischen Baugruppe gemäß einem der Ansprüche 1 bis 9, welches die folgenden Verfahrensschritte aufweist: Bestücke n der ersten Seite (5) des Schaltungsträgers (3) mit einer ersten Gruppe elektronischer Bauteile (2) zur Gestaltung der Benutzerschnittstelle der Baugruppe; Bestücken der zweiten Seite (7) des Schaltungsträgers (3) mit einer zweiten Gruppe elektronischer Bauteile (4) zur Gestaltung eines Rechner- und Steuermoduls der Baugruppe; und c) Einrichten von Signalübertragungs- und/oder Leistungsversorgungsverbindungen zwischen der ersten Seite (5) und der zweiten Seite (7).

11. Verfahren gemäß Anspruch 10, **dadurch gekennzeichnet, dass** der Verfahrensschritt c) ferner folgende Verfahrensschritte aufweist: Ausbilden von Steckbereichen (12), die sich an einem Randbereich (11) gegenüberliegend und miteinander konjugierend auf der ersten Seite (5) und der zweiten Seite (7) des Schaltungsträgers (3) erstrecken; und Aufstecken des Steckelements (8) auf die gegenüberliegend ausgebildeten und miteinander konjugierenden Steckbereiche (12).

12. Verfahren gemäß Anspruch 10 oder 11, **dadurch gekennzeichnet, dass** der Verfahrensschritt c) ferner folgende Verfahrensschritte aufweist: Ausbilden von zumindest einem ersten Kontaktbereich (13) auf der ersten Seite (5) des Schaltungsträgers (3) und von zumindest einem zweiten Kontaktbereich (13') auf der zweiten Seite (7) des Schaltungsträgers (3); und Verbinden des zumindest einen ersten Kontaktbereiches (13) mit dem zumindest einen zweiten Kontaktbereich (13') mittels eines Leiterelements (9).

13. Verfahren gemäß einem der Ansprüche 10 bis 12, **dadurch gekennzeichnet, dass** der Verfahrensschritt c) ferner folgende Verfahrensschritte aufweist: Ausbilden von zumindest einem Durchgangsloch (15) in dem Schaltungsträger (3); Ausbilden von zumindest einem ersten Kontaktbereich (14) auf der ersten Seite (5) des Schaltungsträgers (3) und von zumindest einem zweiten Kontaktbereich (14') auf der zweiten Seite (7) des Schaltungsträgers (3); und Einsetzen eines Durchkontaktierungselement (10) in das zumindest eine Durchgangsloch (15), um den zumindest einen ersten Kontaktbereich (14) mit dem zumindest einen zweiten Kontaktbereich (14') elektrisch zu verbinden.

## Claims

1. Electronic subassembly comprising at least one circuitboard (3) coated on two sides with an electrically conductive material, wherein the circuitboard (3) is equipped with a first group of electronic components (2) for formation of a user interface with a second group of electronic components (4) for formation of a computing and control module, **characterised in that** the first group of electronic components (2) for formation of a user interface is mounted and electrically contactable on a first side (5) of the circuitboard (3) and the second group of electronic components (4) for formation of the computing and control module is mounted and electrically contactable on a second side (7), which is opposite the first side (5), of the circuitboard (3).

2. Electronic subassembly according to claim 1, **characterised in that** the circuitboard (3) is free of through-hole contacting locations, in particular STH through-hole contacting locations.

3. Electronic subassembly according to claim 1 or 2, **characterised in that** the circuitboard (3) has at least one signal transmission device (6) for alternate transmission of control signals between the first group of electronic components (2) on the first side (5) of the circuitboard (3) and the second group of electronic components (4) on the second side (7) of the circuitboard (3) and/or for supply of the first side (5) with electrical power by way of the second side (7) or conversely.

4. Electronic subassembly according to claim 3, **characterised in that** the signal transmission device (6) comprises at least one plug element (8) which is plugged at an edge region (11) of the circuitboard (3) by way of plug regions (12) which are formed oppositely on the first and second sides (5; 7) of the circuitboard (2) and are conjugate with one another.

5. Electronic subassembly according to claim 3 or 4, **characterised in that** the signal transmission device (6) comprises at least one conductor element (9), particularly a cable jumper, which electrically connects a first contact region (13) on the first side (5) of the circuitboard (3) with a second contact region (13') on the second side (7) of the circuitboard (3).

6. Electronic subassembly according to one of claims 3 to 5, **characterised in that** the signal transmission device (6) has at least one through-hole contacting element (10) which runs through a passage hole (15) in the circuitboard (3) and electrically connects a first contact region (14) on the first side (5) of the circuitboard (3) with a second contact region (14) on the second side (7) of the circuitboard (3).

7. Electronic subassembly according to claim 6, **characterised in that** the through-hole contacting element (10) is a plug element which is constructed as, in particular, a plate and which has a planar contact surface (16) and a pin region (17), which is resiliently connected with the contact surface (16) by way of a spring section (18), wherein the contact surface (16) rests flushly on the contact region (14, 14') of the circuitboard (3) and wherein the pin region (17) runs through the passage hole (15) when the plug element (10) as through-hole contacting element (10) is inserted into the passage hole (15).

8. Electronic subassembly according to one of the preceding claims, **characterised in that** the first group of electronic components (2) are components fitted by means of SMD technology on an SMD region (19) of the first side (5) of the circuitboard (3) and the second group of electronic components (4) are not only components fitted by means of SMD technology on an SMD region (19') of the second side (7) of the circuitboard (3), but also components fitted by means of THD technology on a THD region (20') of the second side (7) of the circuitboard (3), wherein the THD region (20') of the second side (7) is different from the SMD region (19') of the second side (7) and wherein the SMD region (19') of the second side (7) is a region corresponding with, but opposite to the SMD region (19) of the first side (3).

9. Electronic subassembly according to one of claims 1 to 7, **characterised in that** the first group of electronic components (2) are not only components fitted by means of SMD technology on an SMD region (19) of the first side (5) of the circuitboard, but also components fitted by means of THD technology on a THD region (20) of the first side (5) of the circuitboard (3), and the second group of electronic components (4) are components fitted by means of SMD technology on an SMD region (19') of the second side (7) of the circuitboard (3), wherein the THD region (20) of the first side (5) is different from the SMD region (19) of the first side (5) and wherein the SMD region (19') of the second side (7) is a region corresponding with, but opposite to the SMD region (19) of the first side (3).

10. Method of producing an electronic subassembly according to one of claims 1 to 9, which comprises the following method steps: equipping the first side (5) of the circuitboard (3) with a first group of electronic components (2) for formation of the user interface of the subassembly; equipping the second side (7) of the circuitboard (3) with a second group of electronic components (4) for formation of a computing and control module of the subassembly; and c) arranging signal transmission and/or power supply connections between the first side (5) and the second side (7).

11. Method according to claim 10, **characterised in that** the method step c) further comprises the following method steps: constructing plug regions (12), which extend on the first side (5) and the second side (7) of the circuitboard (3) at an edge region (11) opposite to and conjugate with one another; and plugging the plug element (8) on the plug regions (12) constructed to be opposite to and conjugate with one another.

12. Method according to claim 10 or 11, **characterised in that** the method step c) further comprises the following method steps: constructing at least one first contact region (13) on the first side (5) of the circuitboard (3) and at least one second contact region (13') on the second side (7) of the circuitboard (3); and connecting the at least one first contact region (13) with the at least one second contact region (13') by means of a conductor element (9).

13. Method according to one of claims 10 to 12, **characterised in that** the method step c) further comprises the following method steps: constructing at least one passage hole (15) in the circuitboard (3); constructing at least one first contact region (14) on the first side (5) of the circuitboard (3) and at least one second contact region (14') on the second side (7.) of the circuitboard (3); and inserting a through-hole contacting element (10) in the at least one passage hole (15) in order to electrically connect the at least one first contact region (14) with the at least one second contact region (14').

## Revendications

1. Ensemble électronique, qui présente au moins un support de circuit (3) recouvert sur les deux côtés avec un matériau électroconducteur, le support de circuit (3) étant équipé d'un premier groupe de composants (2) électroniques pour la conception d'une interface utilisateur et d'un second groupe de composants (4) électroniques pour la conception d'un module d'ordinateur et de commande, **caractérisé en ce que** le premier groupe des composants (2) électroniques pour la conception de l'interface utilisateur et le second groupe des composants (4) électroniques pour la conception de module d'ordinateur et de commande sont appliqués et mis en contact respectivement sur un premier côté (5) du support de circuit (3) et sur un second côté (7), opposé au premier côté (5), du support de circuit (3).

2. Ensemble électronique selon la revendication 1, **caractérisé en ce que** le support de circuit (3) est exempt d'emplacements de connexion transversale, en particulier d'emplacements de connexion transversale STH.

3. Ensemble électronique selon la revendication 1 ou 2, **caractérisé en ce que** le support de circuit (3) présente au moins un dispositif de transmission de signal (6) pour la transmission réciproque de signaux de commande entre le premier groupe des composants (2) électroniques sur le premier côté (5) du support de circuit (3) et le second groupe des composants (4) électroniques sur le second côté (7) du support de circuit (3) et/ou pour l'alimentation du premier côté (5) avec de la puissance électrique par le second côté (7) ou inversement.

4. Ensemble électronique selon la revendication 3, **caractérisé en ce que** le dispositif de transmission de signal (6) présente au moins un élément enfichable (8), qui est enfiché sur un bord périphérique (11) du support de circuit (3) au moyen de zones enfichables (12) opposées, réalisées sur le premier et le second côté (5, 7) du support de circuit (3) et se complétant entre eux.

5. Ensemble électronique selon la revendication 3 ou 4, **caractérisé en ce que** le dispositif de transmission de signal (6) présente au moins un élément conducteur (9), en particulier un cavalier pour câble, qui relie électriquement une première zone de contact (13) sur le premier côté (5) du support de circuit (3) à une seconde zone de contact (13') sur le second côté (7) du support de circuit (3).

6. Ensemble électronique selon l'une quelconque des revendications 3 à 5, **caractérisé en ce que** le dispositif de transmission de signal (6) présente au moins un élément de connexion transversale (10), qui passe à travers un trou de passage (15) dans le support de circuit (3) et relie électriquement une première zone de contact (14) sur le premier côté du support de circuit (3) à une seconde zone de contact (14') sur le second côté (7) du support de circuit (3).

7. Ensemble électronique selon la revendication 6, **caractérisé en ce que** l'élément de connexion transversale (10) est un élément enfichable réalisé en particulier à base de tôle, qui présente une surface de contact (16) pleine et une zone de broche (17), laquelle est reliée par une partie de ressort (18) de façon élastique à la surface de contact (16), la surface de contact (16) s'appliquant sur le même niveau sur la zone de contact (14, 14') du support de circuit (3) et la zone de broche (17) traversant le trou de passage (15) lorsque l'élément enfichable (10) est inséré comme élément de connexion transversale (10) dans le trou de passage (15).

8. Ensemble électronique selon l'une quelconque des revendications précédentes, **caractérisé en ce que** le premier groupe des composants (2) électroniques est constitué de composants équipés au moyen d'une technologie SMD sur une zone SMD (19) du premier côté (5) du support de circuit (3) et le second groupe des composants (4) électroniques est constitué de composants équipés aussi bien avec une technologie SMD sur une zone SMD (19') du second côté (7) du support de circuit (3) qu'au moyen d'une technologie THD sur une zone THD (20') du second côté (7) du support de circuit (3), la zone THD (20') du second côté (7) étant différente de la zone SMD (19') du second côté (7) et la zone SMD (19') du second côté (7) étant une zone correspondante et opposée à la zone SMD (19) du premier côté (3).

9. Ensemble électronique selon l'une quelconque des revendications 1 à 7, **caractérisé en ce que** le premier groupe des composants (2) électroniques est constitué aussi bien de composants équipés d'une technologie SMD sur une zone SMD (19) du premier côté (5) du support de circuit que de composants équipés au moyen d'une technologie THD sur une zone THD (20) du premier côté (5) du support de circuit (3), et le second groupe de composants électroniques (4) est constitué de composants équipés au moyen d'une technologie SMD sur une zone SMD (19') du second côté (7) du support de circuit (3), la zone THD (20) du premier côté (5) étant différente de la zone SMD (19) du premier côté (5) et la zone SMD (19') du second côté (7) étant une zone correspondante et opposée à la zone SMD (19) du premier côté (3).

10. Procédé pour fabriquer un ensemble électronique selon l'une quelconque des revendications 1 à 9, qui présente les étapes de procédé suivantes : équipement du premier côté (5) du support de circuit (3) avec un premier groupe de composants (2) électroniques pour la conception d'une interface utilisateur de l'ensemble, équipement du second côté (7) du support de circuit (3) avec un second groupe de composants électroniques (4) pour la conception d'un module d'ordinateur et de commande de l'ensemble ; et c) mise en place de dispositifs de transmission de signal et/ou d'alimentation en puissance contre le premier côté (5) et le second côté (7).

11. Procédé selon la revendication 10, **caractérisé en ce que** l'étape de procédé c) présente également les étapes de procédé suivantes : réalisation de zones enfichables (12), qui s'étendent sur une zone périphérique (11) de façon opposée et complémentaire sur le premier côté (5) et le second côté (7) du support de circuit (3) ; et enfichage de l'élément enfiché (8) sur les zones enfichables (12) réalisées de façon opposée et se complétant entre elles.

12. Procédé selon la revendication 10 ou 11, **caractérisé en ce que** l'étape de procédé c) présente également les étapes de procédé suivantes : réalisation d'au moins une première zone de contact (13) sur le premier côté (5) du support de circuit (3) et d'au moins une seconde zone de contact (13') sur le second côté (7) du support de circuit (3) ; et liaison de la au moins une première zone de contact (13) avec la au moins une seconde zone de contact (13') au moyen d'un élément conducteur (9).

13. Procédé selon l'une quelconque des revendications 10 à 12, **caractérisé en ce que** l'étape de procédé c) présente également les étapes de procédé suivantes : réalisation d'au moins un trou de passage (15) dans le support de circuit (3) ; réalisation d'au moins une première zone de contact (14) sur le premier côté (5) du support de circuit (3) et d'au moins une seconde zone de contact (14') sur le second côté (7) du support de circuit (3) ; et insertion d'un élément de connexion transversale (10) dans le au moins un trou de passage (15), afin de relier électriquement la au moins une première zone de contact (14), avec la au moins une seconde zone de contact (14').
